# EUROPEAN PATENT APPLICATION

(11) **EP 4 443 674 A1**
(43) Date of publication of application: **09.10.2024**
(21) Application number: 24166009.1
(22) Date of filing: 25.03.2024
(51) Int. Cl.: H01S 5/183, H01S 5/20, H01S 5/30, H01S 5/42, H01S 5/042, H01S 5/02

(54) **BOTTOM SURFACE EMITTING VERTICAL CAVITY SURFACE EMITTING LASER**

(30) Priority: 27.03.2023 US 202363492354 P; 29.11.2023 US 202318522647
(71) Applicant: II-VI Delaware, Inc., Wilmington, DE 19890 (US)
(72) Inventor: BARBAROSSA, Giovanni, Wilmington, 19890 (US); TATARCZAK, Anna, Wilmington, 19890 (US); KOCOT,, Christopher, Wilmington, 19890 (US)
(74) Representative: Schmidt, Christian

(57) **Abstract**

This disclosure describes a bottom surface emitting vertical cavity surface emitting laser (BSE VCSEL) with a lithographically defined aperture. The BSE VCSEL may be oxide-free. Two contacts are located above a substrate. An aperture and one or more active regions are located between two DBRs. A first contact is coupled to the substrate and the first DBR, which is below the aperture. A second contact is coupled to the second DBR, which is above the aperture.

## Description

### BACKGROUND

Limitations and disadvantages of traditional bottom surface emitting vertical cavity surface emitting laser (BSE VCSEL) devices will become apparent to one of skill in the art, through comparison of such approaches with some aspects of the present method and system set forth in the remainder of this disclosure with reference to the drawings.

### BRIEF SUMMARY

Systems and methods are provided for a BSE VCSEL device with a lithographically defined aperture, substantially as illustrated by and/or described in connection with at least one of the figures, as set forth more completely in the claims.

### BRIEF DESCRIPTION OF THE DRAWINGS

FIG. 1 illustrates an example single junction BSE VCSEL with a lithographically defined aperture, in accordance with various example implementations of this disclosure.
FIG. 2 illustrates an example array of two single junction BSE VCSELs with a lithographically defined aperture, in accordance with various example implementations of this disclosure.
FIG. 3 illustrates a first example multi-junction BSE VCSEL with a lithographically defined aperture, in accordance with various example implementations of this disclosure.
FIG. 4 illustrates a second example multi-junction BSE VCSEL with a lithographically defined aperture, in accordance with various example implementations of this disclosure.
FIG. 5 illustrates a third example multi-junction BSE VCSEL with a lithographically defined aperture, in accordance with various example implementations of this disclosure.
FIG. 6 illustrates a fourth example multi-junction BSE VCSEL with a lithographically defined aperture, in accordance with various example implementations of this disclosure.

### DETAILED DESCRIPTION

This disclosure describes a bottom surface emitting vertical cavity surface emitting laser (BSE VCSEL) with a lithographically defined aperture. Systems and methods are provided for a BSE VCSEL comprising a lithographically defined aperture that enables a small emitter spacing.

VCSELs with lithographically defined apertures have a better modal content control and reliability. Additionally, lithographically defined apertures enable smaller emitter spacing. The aperture of existing BSE VCSEL devices may be defined by an oxidation process of AllnGaAs. The oxide aperture has the disadvantage of requiring a larger emitter to emitter spacing in an array due to an added oxidation distance. Accordingly, the disclosed BSE VCSEL may comprise an oxide-free aperture.

When the disclosed BSE VCSEL designs comprise an oxide-free aperture, the emitter spacing may be smaller than in a traditional oxide-based BSE VCSEL. Accordingly, there is no need for oxidation distance spacing in the disclosed oxide-free BSE VCSEL design.

The disclosed BSE VCSEL designs enable a precise optical aperture (OA) and mode control. High reproducibility of the aperture shape and size enable the manufacturability of small apertures (e.g., greater than 0.5 µm). The aperture of the BSE VCSEL may be lithographically defined allowing precision accuracy down to 10nm. The aperture may be defined through a tunnel junction (Tj) for gain guiding. Alternatively, the aperture may be defined through an index step for index guiding.

The mode shape and content can be designed and matched to the backside optics requirements. Various circular or polygonal (e.g., triangular, rectangular, hexagonal) shapes of the OA can be lithographically defined,. Placement and number of apertures depends on the design.

The lithographically defined aperture implementation may be applied to both a single-junction and a multi-junction BSE VCSEL. One or more apertures may be designed and lithographically defined to obtain the required modal content and divergence angle at the device output. Each aperture can be defined in the tunnel junction layer or through an index step.

The disclosed BSE VCSEL designs may enable an improved current spreading as compared to a top emitter. The disclosed BSE VCSEL designs may also enable large apertures that are manufacturable. Such large apertures (e.g., >100µm) enable high optical output power. The disclosed BSE VCSEL designs may enable an improved reliability due to a lack of an oxide layer. The disclosed BSE VCSEL designs may enable an electrical connection on the opposite side from the optical output, which simplifies vertical integration. The disclosed BSE VCSEL designs may enable better over-temperature performance according to an improved heat dissipation.

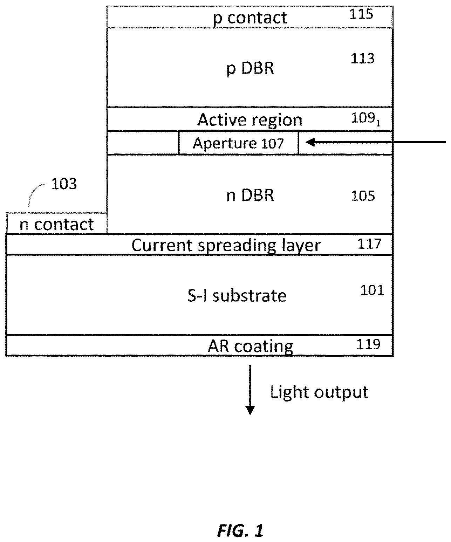

FIG. 1 illustrates an example single junction BSE VCSEL with a lithographically defined aperture, in accordance with various example implementations of this disclosure.

The single junction BSE VCSEL of FIG. 1 comprises a substrate 101, an n contact 103, an n distributed Bragg reflector (n DBR) 105, an aperture 107, an active region 109₁, a p DBR 113 and a p contact 115. The n contact 103 is coupled to the side of the n DBR 105. The substrate 101 may be semi-insulating (S-I). The substrate 101 may be covered by an anti-reflective (AR) coating 119 on the bottom side. The substrate 101 may be covered by a current spreading layer 117 on the top side, adjacent to the n contact 103 and the n DBR 105. The light is output from the bottom of the BSE VCSEL as shown.

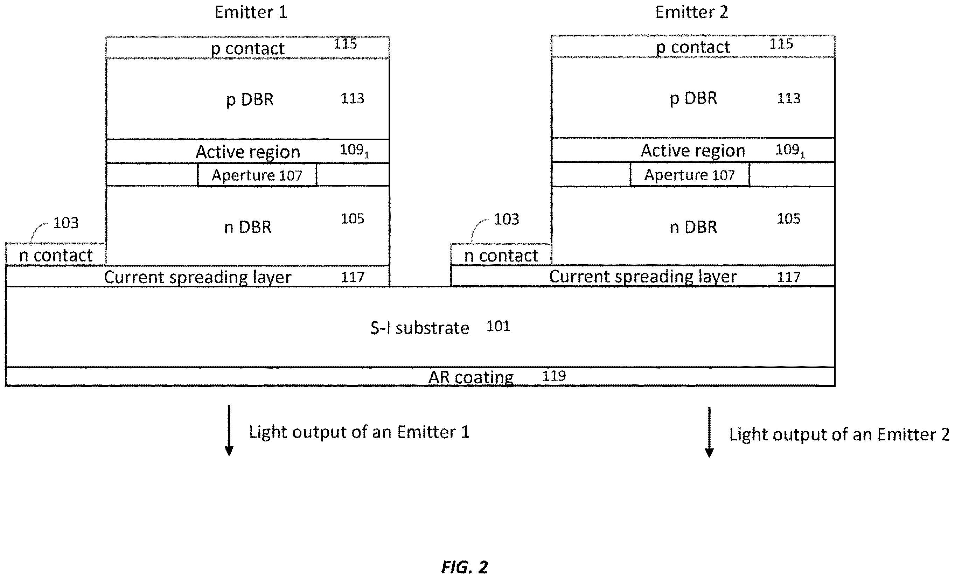

FIG. 2 illustrates an example array of 2 single junction BSE VCSELs with a lithographically defined aperture, in accordance with various example implementations of this disclosure. An array may comprise 2 or more emitters.

Each single junction BSE VCSEL (emitter) of FIG. 2 comprises an n contact 103, an n DBR 105, an aperture 107, an active region 109₁, a p DBR 113 and a p contact 115. The n contact 103 is coupled to the side of the n DBR 105. The substrate 101 may be semi-insulating. All of the single junction BSE VCSELs of an array may be located on a single substrate 101. The single substrate 101 may be covered by an AR coating 119 on the bottom side. The substrate 101 may be covered by a current spreading layer 117 on the top side, adjacent to each n contact 103 and each n DBR 105. The current spreading layer 117 under each emitter is not electrically coupled to the current spreading layer 117 under every other emitter. The light from all of the BSE VCSELs of an array is output from the bottom of the BSE VCSEL as shown.

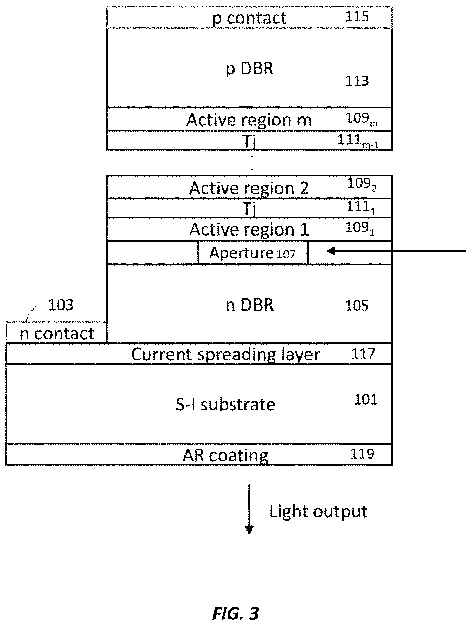

FIG. 3 illustrates a first example multi-junction BSE VCSEL with a lithographically defined aperture, in accordance with various example implementations of this disclosure.

The multi-junction BSE VCSEL of FIG. 3 comprises a substrate 101, an n contact 103, an n DBR 105, an aperture 107, a plurality of active regions 109₁ - 109ₘ separated by one or more tunnel junctions (Tjs) 111₁ - 111ₘ₋₁, a p DBR 113 and a p contact 115. The n contact 103 is coupled to the side of the n DBR 105. The substrate 101 may be semi-insulating. The substrate 101 may be covered by an AR coating 119 on the bottom side. The substrate 101 may be covered by a current spreading layer 117 on the top side, adjacent to the n contact 103 and the n DBR 105. The light is output from the bottom of the multi-junction BSE VCSEL as shown.

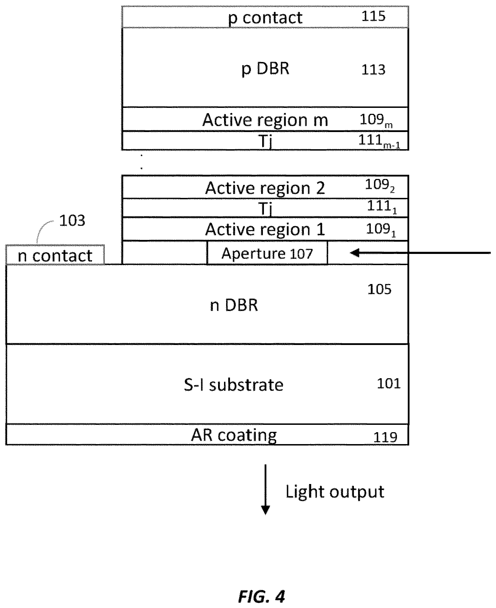

FIG. 4 illustrates a second example multi-junction BSE VCSEL with a lithographically defined aperture, in accordance with various example implementations of this disclosure.

The multi-junction BSE VCSEL of FIG. 4 comprises a substrate 101, an n contact 103, an n DBR 105, an aperture 107, a plurality of active regions 109₁ - 109ₘ separated by one or more tunnel junctions (Tjs) 111₁ - 111ₘ₋₁, a p DBR 113 and a p contact 115. The substrate 101 may be semi-insulating. The substrate 101 may be covered by an AR coating 119 on the bottom side. The multi-junction BSE VCSEL of FIG. 4 comprises an intra-cavity n contact 103. The substrate 101 of FIG. 4 is directly coupled to the n DBR 105, and the n contact 103 is located on top of the n DBR 105. The light is output from the bottom of the multi-junction BSE VCSEL as shown.

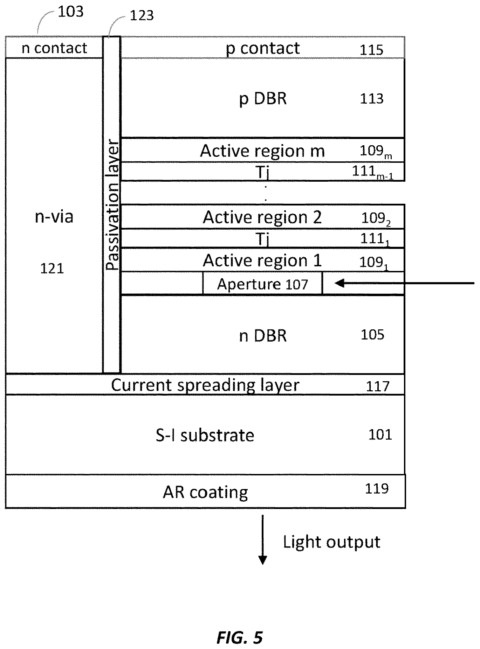

FIG. 5 illustrates a third example multi-junction BSE VCSEL with a lithographically defined aperture, in accordance with various example implementations of this disclosure.

The multi-junction BSE VCSEL of FIG. 5 comprises a substrate 101, an n contact 103, an n DBR 105, an aperture 107, a plurality of active regions 109₁ - 109ₘ separated by one or more tunnel junctions (Tjs) 111₁ - 111ₘ₋₁, a p DBR 113 and a p contact 115. The substrate 101 may be semi-insulating. The substrate 101 may be covered by an AR coating 119 on the bottom side. In the multi-junction BSE VCSEL of FIG. 5, the n contact 103 is planarized through a n-via 121. A passivation layer 123 isolates the n contact 103 from the p contact 115. The substrate 101 may be covered by a current spreading layer 117 on the top side, adjacent to the n-via 121 and the n DBR 105. The light is output from the bottom of the multi-junction BSE VCSEL as shown.

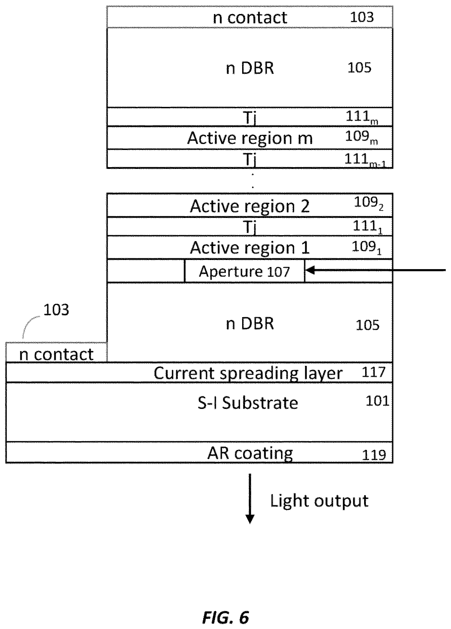

FIG. 6 illustrates a fourth example multi-junction BSE VCSEL with a lithographically defined aperture, in accordance with various example implementations of this disclosure.

The multi-junction BSE VCSEL of FIG. 6 comprises a substrate 101, a first n contact 103₁, a second n contact 103₂, a first n DBR 105₁, a second n DBR 105₂, an aperture 107, a plurality of active regions 109₁ - 109ₘ, and a plurality of tunnel junctions (Tjs) 111₁ - 111ₘ. Each tunnel junction converts electrons into holes to produce a p-region between a tunnel junction and an active region. The substrate 101 may be semi-insulating. The substrate 101 may be covered by an AR coating 119 on the bottom side. In the multi-junction BSE VCSEL of FIG. 6, the first n contact 103₁ is coupled to the side of the first n DBR 105₁ below the aperture 107, and the second n contact 103₂ is coupled to the top of the second n DBR 105₂ above the aperture 107. The substrate 101 may be covered by a current spreading layer 117 on the top side, adjacent to the first n contact 103 and the first n DBR 105. The light is output from the bottom of the multi-junction BSE VCSEL as shown.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:
1. A system, comprising:
   a first bottom surface emitting vertical cavity surface emitting laser (BSE VCSEL) comprising:
   a substrate operable to output a light signal from a bottom side,
   a first contact,
   a first distributed Bragg reflector (DBR) operably coupled to a top side of the substrate and the first contact,
   a first aperture directly coupled to a top side of the first DBR, wherein the first aperture is lithographically defined,
   a first active region directly coupled to a top side of the first aperture,
   a second DBR operably coupled to a top side of the first active region, and
   a second contact directly coupled to a top side of the second DBR.
2. The system of aspect 1, wherein the substrate is semi-insulating.
3. The system of aspect 1, wherein the substrate is covered by an anti-reflective coating on the bottom side.
4. The system of aspect 1, wherein the substrate is covered by a current spreading layer on the top side.
5. The system of aspect 1, wherein:
   the first contact is an n contact, and
   the second contact is a p contact.
6. The system of aspect 1, wherein:
   the first DBR is an n DBR, and
   the second DBR is a p DBR.
7. The system of aspect 1, wherein:
   the first contact is an n contact, and
   the second contact is an n contact.
8. The system of aspect 1, wherein:
   the first DBR is an n DBR,
   the first BSE VCSEL comprises a tunnel junction above the first active region,
   the second DBR is an n DBR, and
   the second DBR directly coupled to the tunnel junction.
9. The system of aspect 1, wherein the system comprises a second BSE VCSEL comprising:
   a third contact operably coupled to a top side of the substrate,
   a third DBR operably coupled to the top side of the substrate,
   a second aperture directly coupled to a top side of the third DBR,
   a second active region directly coupled to a top side of the second aperture,
   a fourth DBR operably coupled to a top side of the second active region, and
   a fourth contact directly coupled to a top side of the fourth DBR.
10. The system of aspect 9, wherein the substrate is covered by a current spreading layer on the top side, and wherein the current spreading layer under the first DBR is separated from the current spreading layer under the third DBR.
11. The system of aspect 1, wherein:
   the first BSE VCSEL comprises a plurality of active regions,
   the plurality of active regions comprise the first active region, and
   the plurality of active regions are separated by a tunnel junction.
12. The system of aspect 1, wherein the first contact is directly coupled to a top side of the first DBR.
13. The system of aspect 1, wherein a shape of the aperture is one of a circle and a polygon.
14. The system of aspect 1, wherein the aperture is defined, via a tunnel junction, for gain guiding.
15. The system of aspect 1, wherein the aperture is defined, via an index step, for index guiding.
16. The system of aspect 1, wherein the aperture is greater than 0.5µm.
17. The system of aspect 1, wherein:
   the first contact is planarized through a via, and
   the first BSE VCSEL comprises a passivation layer that isolates the first contact from the second contact.

Implementations as described herein may relate to the following: A system comprising a bottom surface emitting vertical cavity surface emitting laser (BSE VCSEL) with a lithographically defined aperture. The BSE VCSEL may be oxide-free. Two contacts are located above a substrate. An aperture and one or more active regions are located between two DBRs. A first contact is coupled to the substrate and the first DBR, which is below the aperture. A second contact is coupled to the second DBR, which is above the aperture.

The present application claims priorities of U.S. Patent Application No. 63/492,354, filed March 27, 2023, and U.S. Patent Application No. 18/522,647, filed November 29, 2023. The entire disclosure of these applications is hereby explicitly incorporated by reference into the present application.

As used herein the terms "circuits" and "circuitry" refer to physical electronic components (i.e. hardware) and any software and/or firmware ("code") which may configure the hardware, be executed by the hardware, and or otherwise be associated with the hardware. As used herein, for example, a particular processor and memory may comprise a first "circuit" when executing a first one or more lines of code and may comprise a second "circuit" when executing a second one or more lines of code. As used herein, "and/or" means any one or more of the items in the list joined by "and/or". As an example, "x and/or y" means any element of the three-element set {(x), (y), (x, y)}. As another example, "x, y, and/or z" means any element of the seven-element set {(x), (y), (z), (x, y), (x, z), (y, z), (x, y, z)}. As used herein, the term "exemplary" means serving as a non-limiting example, instance, or illustration. As used herein, the terms "e.g.," and "for example" set off lists of one or more non-limiting examples, instances, or illustrations. As used herein, circuitry is "operable" to perform a function whenever the circuitry comprises the necessary hardware and code (if any is necessary) to perform the function, regardless of whether performance of the function is disabled or not enabled (e.g., by a user-configurable setting, factory trim, etc.). As used herein, the term "based on" means "based at least in part on." For example, "x based on y" means that "x" is based at least in part on "y" (and may also be based on z, for example).

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

## Claims

1. A system, comprising:
a first bottom surface emitting vertical cavity surface emitting laser (BSE VCSEL) comprising:
a substrate operable to output a light signal from a bottom side,
a first contact,
a first distributed Bragg reflector (DBR) operably coupled to a top side of the substrate and the first contact,
a first aperture directly coupled to a top side of the first DBR, wherein the first aperture is lithographically defined,
a first active region directly coupled to a top side of the first aperture,
a second DBR operably coupled to a top side of the first active region, and
a second contact directly coupled to a top side of the second DBR.

2. The system of claim 1, wherein the substrate is semi-insulating.

3. The system of claim 1 or 2, wherein the substrate is covered by an anti-reflective coating on the bottom side.

4. The system of any one of claims 1 to 3, wherein the substrate is covered by a current spreading layer on the top side.

5. The system of any one of claims 1 to 4, wherein:
the first contact is an n contact, and
the second contact is a p contact.

6. The system of any one of claims 1 to 5, wherein:
the first DBR is an n DBR, and
the second DBR is a p DBR.

7. The system of any one of claims 1 to 4 or 6, wherein:
the first contact is an n contact, and
the second contact is an n contact.

8. The system of any one of claims 1 to 5 or 7, wherein:
the first DBR is an n DBR,
the first BSE VCSEL comprises a tunnel junction above the first active region,
the second DBR is an n DBR, and
the second DBR directly coupled to the tunnel junction.

9. The system of any one of claims 1 to 8, wherein the system comprises a second BSE VCSEL comprising:
a third contact operably coupled to a top side of the substrate,
a third DBR operably coupled to the top side of the substrate,
a second aperture directly coupled to a top side of the third DBR,
a second active region directly coupled to a top side of the second aperture,
a fourth DBR operably coupled to a top side of the second active region, and
a fourth contact directly coupled to a top side of the fourth DBR.

10. The system of claim 9, wherein the substrate is covered by a current spreading layer on the top side, and wherein the current spreading layer under the first DBR is separated from the current spreading layer under the third DBR.

11. The system of any one of claims 1 to 10, wherein:
the first BSE VCSEL comprises a plurality of active regions,
the plurality of active regions comprise the first active region, and
the plurality of active regions are separated by a tunnel junction.

12. The system of any one of claims 1 to 11, wherein the first contact is directly coupled to a top side of the first DBR.

13. The system of any one of claims 1 to 12, wherein a shape of the aperture is one of a circle and a polygon.

14. The system of any one of claims 1 to 13, wherein the aperture is defined, via a tunnel junction, for gain guiding.

15. The system of any one of claims 1 to 13, wherein the aperture is defined, via an index step, for index guiding.

16. The system of any one of claims 1 to 15, wherein the aperture is greater than 0.5µm.

17. The system of any one of claims 1 to 16, wherein:
the first contact is planarized through a via, and
the first BSE VCSEL comprises a passivation layer that isolates the first contact from the second contact.
